# EUROPEAN PATENT SPECIFICATION

(11) **EP 1 860 207 B1**
(45) Date of publication and mention of the grant of the patent: **27.07.2011**
(21) Application number: 06715131.6
(22) Date of filing: 03.03.2006
(51) Int. Cl.: C23C 14/34, C22C 1/02, H01L 21/285

(54) **PROCESS FOR TARGET PRODUCTION**
TARGETHERSTELLUNGSVERFAHREN
PROCEDE DE PRODUCTION DE CIBLES

(30) Priority: 10.03.2005 JP 2005066721
(43) Date of publication of application: 28.11.2007
(73) Proprietor: ULVAC, INC., Chigasaki-shi, Kanagawa 253-8543 (JP)
(72) Inventor: OTA, Atsushi, Chiba Institute for super materials, Sanbu-gun, Chiba, 289-1226 (JP); SUGIURA, Isao, Chiba Institute for super materials, Sanbu-gun, Chiba, 289-1226 (JP); TANI, Noriaki, Chiba Institute for super materials, Sanbu-gun, Chiba, 289-1226 (JP); MATSUMOTO, Masahiro, Chiba Inst. super materials, Sanbu-gun, Chiba, 289-1226 (JP); KATAGIRI, Hiroaki, Chiba Inst. for super materials, Sanbu-gun, Chiba, 289-1226 (JP); MASUDA, Tadashi, Sanbu-gun, Chiba 2891297 (JP); ISHIBASHI, Satoru, Chiba Inst. for super materials, Sanbu-gun, Chiba, 289-1226 (JP); ITO, Takaharu, Sanbu-gun, Chiba 2891297 (JP)
(74) Representative: Körber, Martin Hans
(86) International application number: PCT/JP2006/304048
(87) International publication number: WO 2006/095642

(56) References cited:
- WO-A1-99/34028
- JP-A- 10 317 082
- JP-A- 2001 073 124
- US-A1- 2004 191 111
- US-B1- 6 312 833

## Description

### Technical Field

The present invention generally relates to a technical field on the sputtering targets; and more particularly, the invention relates to the technology for producing the targets in which an additive is added into a principal material such as aluminum or the like.

### Background Art

In some cases, thin films for wiring or reflective films are formed by using an Al or Al alloy target.

In a conventional thin film obtained by using the Al target, when the temperature rises during annealing the thin film, Al undergoes grain growth to produce a foreign matter called "a hillock" on a surface of Al. When a wiring film is formed by etching the thin film having this hillock, the shaped patterns of the wiring film are disturbed. Meanwhile, when the reflective film is formed, light diffusely reflects and the film becomes clouded and exhibits a low reflectivity, because foreign matters are present on the surface of the thin film.

In order to avoid the above-mentioned hillocks, there is an Al alloy target in which an additive is added into Al. However, since an additive is dispersed as solid solution into AI in the case of an AI alloy target (such as, AL-C), the specific resistance of the formed thin film of the AI alloy becomes higher as compared to that of the AI thin film.

If the content of the additive is decreased in order to lower the specific resistance, hillocks are formed; and whereas, if the content is increased, the specific resistance becomes greater.

On the other hand, in the case of films of alloys (such as, Al-Nd or the like), annealing can be performed at a high temperature while the production of hillocks is suppressed, and the specific resistance can be reduced by the annealing. With growth in sizes of substrates, however, targets become greater so that power applied to a cathode increases and arc discharge is likely to occur. When the arc discharge occurs, there is a problem in that the target is partially melted and a splash is formed to mix into the thin film. A target in which an additive composed of a rare earth element is added into a principal material made of Al is described in the below-described document, for example.

When the additive (such as, a rare earth element) is incorporated by melting, the additive is likely to react with oxygen in the atmosphere and ignites under heating because the additive capable of suppressing the occurrence of the hillocks is active. For this reason, there is a problem in that the conventional equipment for producing the target through melting becomes large-scaled.
Patent Document 1: JP-A 2001-073124

### Disclosure of the Invention

### Problems to be solved by the Invention

The present invention solve the problems and drawbacks in the production of the targets in the conventional art by incorporating the additive into the principal material by melting, and provides a method for producing a target-constituting material without using a large-scale vacuum chamber.

### Measures to Solve the Problems

In order to solve the above problems of the conventional art, the present invention is directed to a method for producing a target, wherein this method includes preparing a primary alloy in a molten state by adding an additive into a principal material in a first atmosphere, adding the principal material to the primary alloy in a secondary atmosphere to obtain a secondary alloy in a molten state, having a content ratio of the additive lower than that of the primary alloy, producing a sputtering target composed of the secondary alloy, wherein a partial pressure of oxygen in the first atmosphere is lower than a partial pressure of oxygen in the secondary atmosphere wherein further aluminum (A1) is used as the principal material, and wherein an inflammable metal that ignites if it is melted in the atmosphere is used as the additive.

Further, the present invention is the target producing method in which the secondary atmosphere is an atmospheric atmosphere.

Furthermore, the present invention is the target producing method in which the pressure of the first atmosphere is lower than that of the atmospheric atmosphere.

Further, the present invention is the target producing method in which at least one material selected from the group consisting of Ce, Pr, Dy and Y is used as the additive and the additive is incorporated into the sputtering target in the range of 0.5 atm% or more to 5 atm% or less.

Furthermore, the present invention is the target producing method in which a partial pressure of oxygen in the first atmosphere is 0.2Pa or less.

Moreover, the present invention is the target producing method in which the first atmosphere is set at a pressure of 130Pa or more.

In addition, the present invention is the target producing method to form the first atmosphere in a vacuum chamber and to add the additive into the principal material inside the vacuum chamber; and the target producing method further includes reducing the interior of the vacuum chamber to set to a pressure of 1Pa or less; and an inert gas is introduced into the vacuum chamber to set the pressure of 130 Pa or more so as to form the first atmosphere.

The present invention is constructed as mentioned above, and the additive which ignites by heating in the atmosphere, is melted in the first atmosphere with low-level oxygen, and the molten principal material is mixed with the principal material in the molten state, thereby forming the primary alloy. It may be that the molten additive is added into the molten principal material; as such, the solid additive may be alternatively added to the molten principal material to melt the additive, or to the contrary, the solid principal material is added little by little into the molten additive to melt the principal material.

The molten primary alloy may be converted to a solid by cooling in the first atmosphere, or may be cooled after being taken out to the atmosphere, since the primary alloy is stable in the atmosphere even if it contains the additive at a high concentration.

Since the primary alloy does not ignite even if it is melted in the atmosphere, the secondary alloy can be formed by increasing the volume of the primary alloy by adding the principal material to the molten primary alloy in the atmosphere. Therefore, since a large amount of the secondary alloy can be obtained from a small amount of the primary alloy in the atmosphere, the vacuum chamber in which the first atmosphere is formed for the primary alloy can be made smaller than in a case where the additive and the principal material are all melted in a vacuum chamber.

The secondary alloy obtained is a target material. When the secondary alloy is formed in a desired shape (such as, a rectangular plate-like shape, a circular disc shape or the like), a sputtering target is obtained. The sputtering target may be attached to a backing plate of copper.

When the additive is melted into the principal material, the partial pressure of oxygen may be theoretically so high that the additive or the principal material may not be oxidized. The present inventors experimentally confirmed that no ignition occurs if the partial pressure of oxygen in the first atmosphere is set at 0.2Pa or less when the additive is Ce,. It is anticipated that the same condition can be applied to other materials (Pr, Dy or Y).

If the first atmosphere is constituted by an inert gas atmosphere containing no oxygen, the pressure of the first atmosphere may be the atmospheric pressure. However, it is preferable that the interior of the vacuum chamber is evacuated to vacuum so as to remove a gas generated from the melted principal material or the melted additive. For this purpose, it is easy to set the first atmosphere at the pressure lower than the atmospheric pressure.

On the other hand, if the first atmosphere is set at a too low a pressure, a vapor of the principal material or the additive is generated from the molten principal material or the melted additive, it makes the composition of the primary alloy unstable.

Therefore, it is desirable that the first atmosphere is set at less than the atmospheric pressure and higher than a lower limit pressure.

Experiments revealed that the first atmosphere is preferably at the pressure of not less than 130Pa, and that the pressure of the first atmosphere is set preferably at not less than 2600Pa so as to suppress the generation of vapors of aluminum as the principal material and Ce as the additive and to keep the compositional ratio of the first alloy constant.

For this purpose, after oxygen is removed by once vacuum evacuating the interior of the vacuum chamber to a low pressure, it is preferable to form the first atmosphere consisting of the inert gas atmosphere at 130Pa or more, or not less than 2600Pa by introducing the inert gas into the vacuum chamber in order to raise its pressure.

Furthermore, in order to maintain the inert gas atmosphere free from oxygen at less than the atmospheric pressure, it is preferable to continuously perform the vacuum evacuation and the feeding of the inert gas during the formation of the primary alloy.

### Effects of the Invention

According to the present invention, since the inflammable additive is added at the low level-oxygen atmosphere (such as, the vacuum atmosphere or the inert gas atmosphere) having the pressure lower than the atmospheric pressure, there is no fear of ignition.

At that time, after forming the primary alloy in the low level-oxygen atmosphere, the volume of the primary alloy is increased by adding the principal material in the atmospheric pressure. Consequently, a great amount of the target material can be obtained without using a large-scale vacuum chamber.

Furthermore, when the target produced by the present invention is sputtered, no abnormal discharge occurs, and no foreign matter is mixed into a resulting thin film.

In addition, even when the thin film obtained is annealed, defects such as hillocks, whiskers or the like are not developed. Therefore, the sputtering targets, which are suitable for the formation of reflective films as well as of thin films to constitute electrode-wiring materials for electronic devices and apparatuses (such as, liquid crystal displays, etc.) can be obtained.

### Brief Description of the Drawings

Fig. 1 is a view for illustrating a step for producing a primary alloy.
Fig. 2 is a view for illustrating a step for producing a secondary alloy.

### Explanation of Reference Numerals

13, 18 --- Primary alloy, 22, 25 --- secondary alloy

### Best Mode for Carrying out the Invention

The method for producing the sputtering target according to the present invention will be explained.

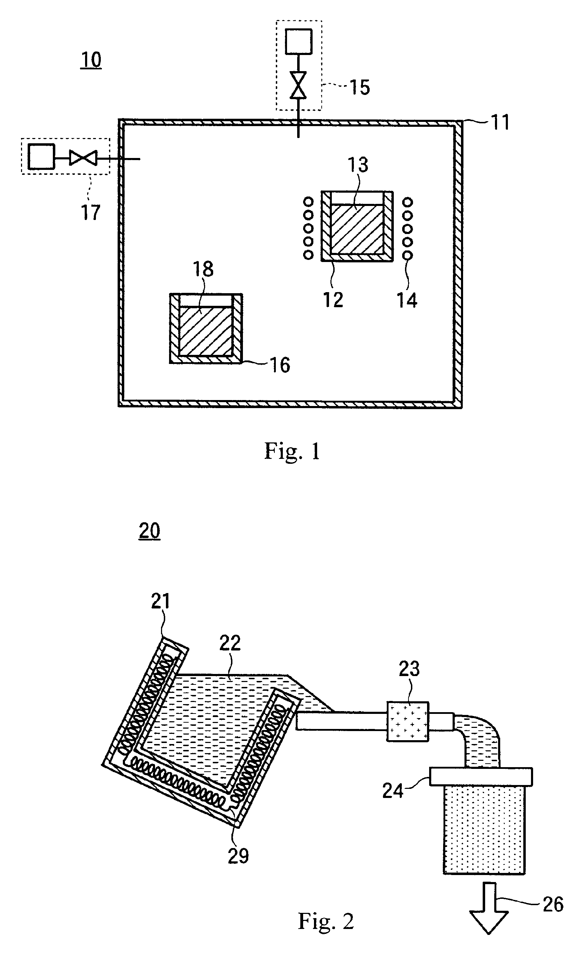

In Fig. 1, a reference numeral 10 denotes a first melting apparatus, which has a vacuum chamber 11.

A first melting crucible 12 is arranged inside the vacuum chamber 11. Meanwhile, an inert gas introducing system 15 and a vacuum evacuating system 17 are connected to the vacuum chamber 11.

First, a principal material (herein, aluminum: Al) and an additive (herein, cerium: Ce) are placed inside the first melting crucible 12 at a predetermined ratio; and the interior of the vacuum chamber 11 is evacuated to vacuum at a pressure of not more than 1Pa by means of the vacuum evacuation system 17.

Then, an inert gas (herein, argon gas) is introduced into the interior of the vacuum chamber 11 through the inert gas introducing system 15; and the interior of the vacuum chamber 11 is pressurized up to 2600Pa; thereby, forming a first atmosphere which has a lower pressure and a lower oxygen pressure than the open atmosphere.

While the vacuum evacuation and the introduction of the inert gas are continuously performed and the first atmosphere having a lower pressure and a lower oxygen pressure than the atmosphere is being maintained, the principal material and the additive inside the first melting crucible 12 are melted under heating by applying current to a high-frequency induction heating coil 14, thereby obtaining a primary alloy 13 in a molten state.

Next, the molten primary alloy 13 is poured, in an inclined manner, into a mold 16 arranged inside the vacuum chamber 11, thereby obtaining the primary alloy (a primary alloy ingot) 18 in a solid condition. In this embodiment, the molten primary alloy is poured, in an inclined manner, into the mold 16 in the first atmosphere.

A metal, (such as, Ce or the like), which is very active in the atmosphere, easily ignites under heating in the atmosphere. A metallic mass of Ce ignites at 160°C in the atmosphere. However, Ce is stabilized through being alloyed with Al, and the primary alloy 18 does not ignite even if taken out to the atmosphere in a molten or solid condition. Further, even if the primary alloy 18 is melted by heating in the atmosphere, it does not ignite.

In Fig. 2, a reference numeral 20 denotes a secondary melting apparatus having a secondary melting crucible 21. This secondary melting crucible 21 is placed in a secondary atmosphere composed of the atmospheric components at the atmospheric pressure.

The primary alloy 18 in the solid condition is placed in the secondary melting crucible 21; a principal material is further added at a given ratio; and the primary alloy 18 and the principal material are melted in the secondary atmosphere by generating heat to applying current to the heater 29; thereby, obtaining a secondary alloy 22 in a molten state. Since the principal material is further added into the primary alloy 18, the ratio of the additive to the principal material in the secondary alloy 22 is lower than the ratio of the additive to the principal material in the primary alloy 13, 18. The amount of the principal material added is set such that the additive may be contained at a desired ratio in the secondary alloy 22.

After a contaminant is removed through a filter 23, the secondary alloy 22 in the molten state is poured, in an inclined manner, into a water-cooled mold 24, and a secondary alloy (a secondary alloy ingot) is obtained in a solid condition by a continuously casting apparatus 26.

The microstructure of the solid secondary alloy is uniformized by plastic working, and a sputtering target having a given size is obtained by mechanical working such as cutting.

A thin-film sample is formed by sputtering a target obtained from the secondary alloy composed of Al as the principal material and Ce as the additive.

With respect to the target in which the additive is added in a range of 1 atm% or more and 10 atm% or less, the resistance value is reduced by annealing the resulting thin film.

In the present invention, the principal material is not limited to Al, but widely encompasses Cu, other metals and meltable materials.

The invention method is suitable for the case where the additive, which ignites at a low temperature in the atmosphere and thus cannot be melted in the atmosphere, is added.

The additive is not limited to Ce, and rare earth elements (such as, Y, Pr, Dy or the like) are suitable for the target as the additive to prevent the hillocks.

Although argon is used as the inert gas in the above method, inert gases (such as, nitrogen gas) besides the rare gases (such as, argon) can be widely used as the inert gas for the formation of the low level-oxygen atmosphere.

Although the pressure-reduced atmosphere of 2600Pa was used as the first atmosphere in the above embodiment, the first atmosphere is not limited to the pressure-reduced atmosphere. Any low level-oxygen atmosphere may suffice as long as the additive does not ignite therein. The inert gas may not necessarily be introduced.

According to the method of the present invention, targets are produced by using Al as the principal material and any one kind of the rare earth elements of Ce, Y, Pr and Dy as an additive, and thereafter, thin films are formed. With the above-described method, the following results were achieved. With respect to the target having not more than 5 atm% of the additive, the resistance values of the thin films were not more than 5µΩcm, which were sufficiently low and equivalent to 3µΩcm in the case of a thin film formed by an aluminum target. Further, the alloy in which 5 atm% of Ce was added to Al had abnormal discharging smaller than in the case of an alloy in which the same amount of Nd was added. Furthermore, the alloys, in which 5 atm% of any one kind of the materials of Ce, Y, Pr and Dy is added less, suffered from the occurrence of foreign matters as compared with those in which more than 5 atm% thereof was added. In addition, when reflective films are formed, it was seen, different from the Al film, that the reflectance (X = 550nm) does not decrease even when the films were annealed at 350°C so that diffuse reflection owing to the occurrence of foreign matters (such as, hillocks) are suppressed.

Therefore, it is preferable to add any one or more kinds of the materials of Ce, Y, Pr and Dy in the range of 1 atm% or more to 5 atm% or less when the Al alloy is produced, for the purpose of decreasing the resistance and suppressing the occurrence of the foreign matters on annealing.

## Claims

1. A method for producing a target, comprising the steps of:
preparing a primary alloy in a molten state by adding an additive into a principal material in a first atmosphere;
adding the principal material to the primary alloy in a secondary atmosphere to obtain a secondary alloy in a molten state having a content ratio of the additive lower than that of the primary alloy; and
producing a sputtering target made of the secondary alloy,
wherein a partial pressure of oxygen in the first atmosphere is lower than a partial pressure of oxygen in the secondary atmosphere,
wherein aluminum (Al) is used as the principal material and wherein an inflammable metal that ignites if it is melted in the atmosphere is used as the additive.

2. The target producing method according to claim 1, wherein the secondary atmosphere is the atmospheric atmosphere.

3. The target producing method according to claim 2, wherein the pressure of the first atmosphere is lower than that of the atmospheric atmosphere.

4. The target producing method according to claim 1, wherein:
at least one material selected from the group consisting of Ce, Pr, Dy and Y is used as the additive, and
the additive is incorporated into the sputtering target in the range of from 0.5 atm% or more to 5 atm% or less.

5. The target producing method according to claim 1, wherein a partial pressure of oxygen in the first atmosphere is set at a pressure of 0.2Pa or less.

6. The target producing method according to claim 5, wherein the first atmosphere is set at a pressure of 130Pa or more.

7. The target producing method according to claim 1 to form the first atmosphere in a vacuum chamber and adding the additive into the principal material inside the vacuum chamber, the target producing method further comprising the steps of;
reducing the interior pressure of the vacuum chamber to set a pressure of 1Pa or less, and then,
introducing an inert gas into the vacuum chamber to set the pressure of 130Pa or more so as to form the first atmosphere.

## Patentansprüche

1. Verfahren zum Herstellen eines Targets, das die Schritte aufweist:
Vorbereiten einer primären Legierung in einem geschmolzenen Zustand durch Hinzufügen eines Additivs in ein Hauptmaterial in einer ersten Atmosphäre;
Hinzufügen des Hauptmaterials zu der primären Legierung in einer sekundären Atmosphäre, um eine sekundäre Legierung in einem geschmolzenen Zustand zu erhalten, die ein Mengenverhältnis des Additivs aufweist, das niedriger ist als das der primären Legierung; und
Herstellen eines Zerstäubungstargets, das aus der sekundären Legierung besteht,
wobei ein Teildruck von Sauerstoff in der ersten Atmosphäre niedriger ist als ein Teildruck von Sauerstoff in der sekundären Atmosphäre,
wobei Aluminium (Al) als das Hauptmaterial verwendet wird und
wobei ein brennbares Metall, das sich entzündet wenn es in der Atmosphäre geschmolzen wird, als das Additiv verwendet wird.

2. Verfahren zur Herstellung eines Targets gemäß Anspruch 1, wobei die sekundäre Atmosphäre die atmosphärische Atmosphäre ist.

3. Verfahren zur Herstellung eines Targets gemäß Anspruch 2, wobei der Druck der ersten Atmosphäre niedriger ist als der der atmosphärischen Atmosphäre.

4. Verfahren zur Herstellung eines Targets gemäß Anspruch 1, wobei:
wenigstens ein Material, das aus der Gruppe bestehend aus Ce, Pr, Dy und Y ausgewählt wird, als das Additiv verwendet wird, und
das Additiv in das Zerstäubungstarget in dem Bereich von 0,5 atm% oder mehr bis 5 atm% oder weniger eingebaut ist.

5. Verfahren zur Herstellung eines Targets gemäß Anspruch 1, wobei ein Teildruck von Sauerstoff in der ersten Atmosphäre auf einen Druck von 0,2 Pa oder weniger eingestellt wird.

6. Verfahren zur Herstellung eines Targets gemäß Anspruch 5, wobei die erste Atmosphäre auf einen Druck von 130 Pa oder mehr eingestellt wird.

7. Verfahren zur Herstellung eines Targets gemäß Anspruch 1, um die erste Atmosphäre in einer Vakuumkammer zu bilden und um das Additiv dem Hauptmaterial innerhalb der Vakuumkammer hinzuzufügen, wobei das Verfahren zur Herstellung eines Targets ferner die Schritte aufweist;
Verringern des Innendrucks der Vakuumkammer, um einen Druck von 1 Pa oder weniger einzustellen, und dann
Einführen eines inerten Gases in die Vakuumkammer, um den Duck von 130 Pa oder mehr einzustellen, um die erste Atmosphäre zu bilden.

## Revendications

1. Procédé de production d'une cible, comprenant les étapes de:
préparer un alliage primaire à l'état fondu en ajoutant un additif au matériau principal dans une première atmosphère;
ajouter le matériau principal à l'alliage primaire dans une atmosphère secondaire pour obtenir un alliage secondaire à l'état fondu ayant un taux de contenu de l'additif inférieur à celui de l'alliage primaire; et
produire une cible de pulvérisation réalisée à partir de l'alliage secondaire,
où la pression partielle de l'oxygène dans la première atmosphère est plus basse qu'une pression partielle de l'oxygène dans l'atmosphère secondaire,
où de l'aluminium (Al) est utilisé comme matériau principal, et où un métal inflammable qui s'allume lorsqu'il est fondu dans l'atmosphère est utilisé comme additif.

2. Procédé de production de cible selon la revendication 1, dans lequel l'atmosphère secondaire est l'atmosphère atmosphérique.

3. Procédé de production de cible selon la revendication 2, dans lequel la pression de la première atmosphère est plus basse que celle de l'atmosphère atmosphérique.

4. Procédé de production de cible selon la revendication 1, dans lequel au moins un matériau sélectionné dans le groupe consistant en Ce, Pr, Dy et Y est utilisé comme additif, et
l'additif est incorporé dans la cible de pulvérisation dans la plage de 0,5 atm% ou plus à 5 atm% ou moins.

5. Procédé de production de cible selon la revendication 1, dans lequel une pression partielle de l'oxygène dans la première atmosphère est réglée à une pression de 0,2Pa ou moins.

6. Procédé de production de cible selon la revendication 5, dans lequel la première atmosphère est réglée à une pression de 130Pa ou plus.

7. Procédé de production de cible selon la revendication 1, pour former la première atmosphère dans une chambre de vide et en ajoutant l'additif au matériau principal à l'intérieur de la chambre de vide, le procédé de production de cible comprenant en outre les étapes de:
réduire la pression intérieure de la chambre de vide pour établir une pression de 1Pa ou moins, et ensuite,
introduire un gaz inerte dans la chambre de vide pour régler la pression de 130Pa ou plus de manière à former la première atmosphère.
